# EUROPÄISCHE PATENTSCHRIFT

(11) **EP 3 142 032 B1**
(45) Veröffentlichungstag und Bekanntmachung des Hinweises auf die Patenterteilung: **16.01.2019**
(21) Anmeldenummer: 15184169.9
(22) Anmeldetag: 08.09.2015
(51) Int. Cl.: G06F 17/50, G05B 19/05

(54) **VERFAHREN ZUM ÄNDERN DER KONFIGURATION EINES PROGRAMMIERBAREN LOGIKBAUSTEINS**
METHOD FOR CHANGING THE CONFIGURATION OF A PROGRAMMABLE LOGIC COMPONENT
PROCÉDÉ DE MODIFICATION DE LA CONFIGURATION D'UN ÉLÉMENT LOGIQUE PROGRAMMABLE

(43) Veröffentlichungstag der Anmeldung: 15.03.2017
(73) Patentinhaber: dSPACE digital signal processing and control engineering GmbH, 33102 Paderborn (DE)
(72) Erfinder: Mertens, Frank, 33175 Bad Lippspringe (DE); Dressler, Marc, 32805 Horn-Bad Meinberg (DE)

(56) Entgegenhaltungen:
- US-B1- 8 786 310

## Beschreibung

Die Erfindung betrifft ein Verfahren zum Ändern der Konfiguration eines programmierbaren Logikbausteins, ein Verfahren zum Anpassen eines Steuergeräts, welches einen zur Ausführung einer Regelfunktion eingerichteten programmierbaren Logikbaustein umfasst, und eine Programmiervorrichtung zum Beschreiben eines programmierbaren Logikbausteins.

In vielen Gebieten der Technik werden Steuergeräte zur Regelung eines physikalischen Prozesses eingesetzt, wobei ein Mikrocontroller des Steuergeräts zyklisch ein Programm abarbeitet, welches die Ermittlung neuer Messwerte eines oder mehrerer Sensoren und die Ansteuerung eines oder mehrerer Aktuatoren basierend auf einem Vergleich der Messwerte mit Sollwerten umfasst. Zur Beschleunigung des Entwurfs neuer Steuergeräte bzw. Regelalgorithmen wird dabei häufig auf einem bestehenden Steuergerät aufgesetzt und lediglich einzelne (Teil-)Funktionen ersetzt. Dieses auch unter dem Begriff Bypassing bekannte Vorgehen kann entweder vollständig auf dem bestehenden Steuergerät umgesetzt werden (internes Bypassing) oder für den Aufruf der neuen Funktion(en), den sogenannten Bypassfunktionen, auf ein gesondertes Rapid Control Prototyping System (abgekürzt RCP-System) zurückgreifen (externes Bypassing). Das Ersetzen einzelner Funktionen kann zweckmäßigerweise durch die Anpassung von Sprungbefehlen erfolgen.

Aus der EP 2869145 A1 ist ein Verfahren zur Beeinflussung eines Steuerprogramms eines Steuergerätes bekannt, wobei das Steuerprogramm eine Vielzahl von ersten Funktionen umfasst, von denen wenigsten eine für die Steuerung eines Aktuators ausgebildet ist, und wobei ein Speicher vorgesehen ist, der mit den ersten Funktionen zugeordneten Unterprogrammen belegte Speicherbereiche aufweist. Das Steuerprogramm liegt als ein binärer Programmkode vor, wobei in dem Programmkode des Steuerprogramms bei dem Aufruf von einer der ersten Funktionen eine Sprungadresse vorliegt, welche auf eine Speicheradresse des mit dem Funktionsaufruf verbundenen Unterprogramms zeigt, und wobei das Unterprogramm als eine Abfolge von binärem Programmkode vorliegt und an dem Ende der Abfolge des Programmkodes des Unterprogramms ein Rücksprungbefehl vorliegt. Der Programmkode des Steuerprogramms wird auf das Auftreten von Funktionsaufrufen untersucht und die mit den Funktionsaufrufen verbundenen Sprungadressen und Adressen der Rücksprungbefehle werden ermittelt, wobei aus der Ermittlung der Größe die mit den jeweiligen Unterprogrammen belegten Speicherbereiche des Speichers ermittelt werden. Die den ersten Funktionen zugeordneten Bezeichner mit den jeweiligen ersten Funktionen zugeordneten Größen und Adressen der Speicherbereiche werden in einer Anzeigeeinheit dargestellt, die als Teil eines Computersystems ausgebildet ist. Mittels des Computersystems wird wenigstens eine der ersten Funktionen als zu löschend ausgewählt, wobei Größe und Adresse der ausgewählten ersten Funktion wird in einer Funktionsstruktur gespeichert und wenigstens ein Funktionsaufruf der ausgewählten ersten Funktion deaktiviert und/oder die erste Funktion durch eine zweite Funktion ersetzt wird, indem der Programmkode der ausgewählten ersten Funktion mittels des Programmkodes der zweiten Funktion überschrieben wird.

Für die Simulation und Regelung von Systemen mit hoher Dynamik werden in zunehmendem Umfang unter dem Begriff Field Programmable Gate Array (abgekürzt FPGA) bekannte programmierbare Logikbausteine eingesetzt, die aufgrund paralleler Verarbeitung und einer für die jeweilige Anwendung maßgeschneiderten Logikschaltung auch schnell veränderliche Strecken zuverlässig regeln. Da anders als bei Mikroprozessoren keine sequentielle Abarbeitung erfolgt und keine Sprungbefehle vorhanden sind, kann für die auf einem FPGA implementierten Regelfunktionen bisher kein Bypassing durchgeführt werden. Ein weiterer Nachteil des Einsatzes von FPGA liegt darin, dass kleine Anpassungen an den einzelnen Logikfunktionen nur eingeschränkt möglich sind, da die Schaltung jeweils vollständig neu synthetisiert werden muss, was insbesondere aufgrund der Optimierung von Platzierung und Routing zeitaufwändig ist. Es wäre daher wünschenswert, eine einfache Möglichkeit zur Anpassung von Logikfunktionen auch für programmierbare Logikbausteine bereitzustellen.

Eine partielle Rekonfiguration ist ein z.B. aus der US 7,902,866 B1 bekanntes Vorgehen, um die Konfiguration eines FPGA nachträglich bzw. zur Laufzeit ändern zu können. Als Vorbereitung hierfür muss die FPGA-Konfiguration bereits in der Entwurfsphase in Partitionen aufgeteilt werden, wobei also beispielsweise eine erste und eine zweite Partition erstellt werden. In der ersten Partition werden unveränderliche bzw. immer vorhandene Logikfunktionen bereitgestellt. Die zweite Partition stellt dann einen abgegrenzten Bereich dar, für den eine partielle Neu-Synthese und eine partielle Rekonfiguration möglich sind, so dass also die auf der zweiten Partition angeordneten Logikfunktionen prinzipiell geändert werden können. Dieses Vorgehen weist allerdings eine Reihe von Nachteilen auf:
- Bereits im Initialdesign müssen die Partitionsschnittstellen geplant und fest implementiert werden.
- Unabhängig von der in der zweiten Partition realisierten Funktionalität bzw. implementierten Logikfunktion ist eine feste Anzahl von Logikeinheiten und Verbindungselementen reserviert. Durch die somit erforderliche Reservierung der größten anzunehmenden Anzahl erforderlicher Logikelemente bleiben in vielen Fällen Ressourcen ungenutzt.
- Alle auf der ersten Partition angeordneten Logikfunktionen bleiben fest; auch dann, wenn die aktuell realisierte Funktionalität der zweiten Partition diese nicht benötigt, bleibt ein Platz- und Energiebedarf der Funktionen erhalten.

Für den Entwurf und die Bearbeitung von FPGA-Konfiguration wurde "Torc: Towards an Open Source Tool Flow", Proceedings of the 19th Annual ACM/SIGDA International Symposium on Field Programmable Gate Arrays, 2011, von N. Steiner et al. vorgestellt, welches beispielsweise eine Logikbeschreibung in Form einer unplatzierten oder platzierten Netzliste lesen und schreiben kann. Aufbauend hierauf beschreiben R. K. Soni et al. in "Open-Source Bitstream Generation", 21st IEEE Annual International Symposium on Field-Programmable Custom Computing Machines 2013, eine Möglichkeit schnelle Modifikationen an einem Bitstrom vorzunehmen, der eine FPGA-Konfiguration beschreibt. Mit Hilfe einer Bibliothek von Mikro-Bitströmen, welche jeweils einzelne Grundeinheiten beschreiben, können auf Basis einer platzierten Netzliste weitere Logikelemente zu einer bestehenden Konfiguration hinzugefügt werden.

Mit "RapidSmith: Do-it-Yourself CAD Tools for Xilinx FPGAs", 2011 21st International Conference on Field Programmable Logic and Applications, von C. Lavin et al. ist ein weiteres Entwurfswerkzeuge für FPGA-Konfigurationen bekannt geworden. Aufbauend hierauf wird in dem Paper "Rapid Post-Map Insertion of Embedded Logic Analyzers for Xilinx FPGAs", 22nd IEEE Annual International Symposium on Field-Programmable Custom Computing Machines 2014, von B. L. Hutchings und J. Keeley eine Möglichkeit beschrieben, eine bestehende FPGA-Konfiguration zu modifizieren, ohne dass eine erneute Kompilierung bzw. Synthese der vollständigen Schaltung erforderlich ist. Unter Verwendung von bisher ungenutzten Logikelementen bzw. Flächen des FPGA können somit nachträglich Mess-Schaltungen in eine ansonsten unveränderte FPGA-Konfiguration eingebracht werden. Eine Anpassung einzelner Logikfunktionen und somit eine Änderung der ausgegebenen Werte bzw. Signale erfolgt nicht.

Aus der US 8,786,310 B1 ist ein Verfahren zum partiellen Rekonfigurieren eines programmierbaren Logikbausteins bekannt. Mittels Konfigurations-Steuerungs-Speicherzellen kann feingranular gesteuert werden, welcher Teil eines Frames beschrieben wird, so dass eine Rekonfiguration mit kleineren Bitströmen möglich wird. Anhand des Entwurfs der Schaltung werden zu diesem Zweck passende Bitströme vorab generiert.

Vor diesem Hintergrund besteht die Aufgabe der Erfindung darin, ein Verfahren und eine Vorrichtung anzugeben, welche den Stand der Technik weiterbilden, und vorzugsweise eine mit dem bekannten Bypassing vergleichbare Funktionalität bei der Entwicklung von programmierbare Logikbausteine umfassenden Steuergeräten ermöglichen.

Die Aufgabe wird durch ein Verfahren zum Ändern der Konfiguration eines Programmierbaren Logikbausteins mit den Merkmalen von Anspruch 1 und eine Programmiervorrichtung mit den Merkmalen von Anspruch 16 gelöst. Vorteilhafte Ausgestaltungen der Erfindung sind Gegenstand von abhängigen Unteransprüchen.

Erfindungsgemäß wird also ein Verfahren zum Ändern der Konfiguration eines programmierbaren Logikbausteins bereitgestellt, bei dem eine Ausgangskonfiguration des programmierbaren Logikbausteins eingelesen wird, so dass eine Logikbeschreibung, insbesondere eine platzierte Netzliste, der Ausgangskonfiguration zumindest teilweise vorliegt, wobei aus der Logikbeschreibung der Ausgangskonfiguration des programmierbaren Logikbausteins ein oder mehrere Logikelemente und/oder Verbindungselemente ersetzt oder umkonfiguriert werden und eine Logikbeschreibung einer Zielkonfiguration erstellt wird, welche ein oder mehrere zusätzliche Logikelemente aufweist, wobei kein, ein oder mehrere Elemente der Ausgangskonfiguration in der Zielkonfiguration nicht genutzt werden. Anhand von Zuordnungsinformationen werden Übergabepunkte bestimmt, also in Ziel- und Ausgangskonfiguration vorhandenen Logikelemente oder deren Ein- oder Ausgänge, insbesondere Register oder Treiber, an denen in der Zielkonfiguration eine geänderte Logikfunktion angelegt wird, wobei zumindest die bereits in der Ausgangskonfiguration nicht genutzten Logikelemente des programmierbaren Logikbausteins als frei markiert werden und wobei die zusätzlichen Logikelemente der Zielkonfiguration auf den als frei markierten Logikelementen platziert und über ungenutzte Verbindungselemente mit den Übergabepunkten verbunden werden. Aus der Logikbeschreibung der Zielkonfiguration wird ein geänderter Bitstrom erstellt und der geänderte Bitstrom wird in den programmierbaren Logikbaustein geschrieben.

Programmierbare Logikbausteine umfassen insbesondere unter den Abkürzungen FPGA, CPLD und PLD bekannte Bausteine, welche eine Vielzahl von Logikelementen und eine Vielzahl von Verbindungselementen besitzen, deren genaue Konfiguration nach einem Neustart des Bausteins anhand eines eingelesenen Bitstroms festgelegt wird. Zu diesem Zweck weisen programmierbare Logikbausteine zweckmäßigerweise einen Konfigurationsspeicher auf, der für jedes Logikelement und jedes schaltbare Verbindungselement zumindest ein Bit umfasst und vorzugsweise aus statischen Speicherzellen (SRAM, insbesondere bei FPGAs) oder nichtflüchtigen Speichern (FLASH, insbesondere bei PLDs) aufgebaut ist.

Unter einem Logikelement sind hierbei elementare Einheiten des programmierbaren Logikbausteins wie Register, Wahrheitstabellen und Verzögerungseinheiten zu verstehen. Vorzugsweise umfassen Logikelemente auch Treiber insbesondere für einen Schnittstellen-Pin eines FPGAs sowie fest vorgegebene dedizierte Logikschaltungen z.B. für eine Multiplikation mehrerer Werte. Mit einem Umkonfigurieren eines Logikelements ist zweckmäßigerweise ein Ändern mindestens einer Eigenschaft des Logikelements gemeint. Beispielsweise würde ein Umkonfigurieren einer Wahrheitstabelle bedeuten, dass mindestens ein Ausgabewert der Tabelle gegenüber der Ausgangskonfiguration verändert ist; im Fall einer dedizierten Logikschaltung könnte das Umkonfigurieren z.B. auch in dem Anlegen eines Taktes bzw. dem Aktivieren oder Deaktivieren der dedizierten Logikschaltung bestehen.

Das Ersetzen oder Umkonfigurieren von ein oder mehreren Logikelementen und/oder Verbindungselementen der Ausgangskonfiguration erfolgt bevorzugt anhand von Zuordnungsinformationen, die insbesondere von dem Hersteller der Ausgangskonfiguration zur Verfügung gestellt worden sein können. Wenn keine vollständige Logikbeschreibung der Ausgangskonfiguration vorliegt, so umfassen die Zuordnungsinformationen zweckmäßigerweise zumindest verfügbare Eingabesignale und mögliche Ausgabepunkte. Die Zuordnungsinformationen können eine direkt vom Hersteller der Ausgangskonfiguration angegebene Liste von Übergabepunkten umfassen; alternativ oder ergänzend kann der Nutzer einen oder mehrere Übergabe punkte vorgeben. An einen Übergabepunkt wird insbesondere dann eine geänderte Logikfunktion angelegt, wenn der Signalpfad eines Eingangs des Übergabepunkts mindestens ein zusätzliches oder umkonfiguriertes Logikelement enthält. Logikfunktionen umfassen zweckmäßigerweise eine Anzahl von aufeinanderfolgenden Logikelementen, wobei zumindest teilweise ein Ausgang eines ersten Logikelements mit einem Eingang eines zweiten Logikelements verbunden ist, so dass ein durchgehender Signalpfad von einem Eingang der Logikfunktion zu einem Ausgang besteht. Bevorzugt werden Logikfunktionen ausgehend von einem für den Empfang von Signalen konfigurierten Schnittstellen-Pin des programmierbaren Logikbausteins betrachtet.

Mit zusätzlichen Logikelementen der Zielkonfiguration sind solche Logikelemente gemeint, welche in der Zielkonfiguration in einem Signalpfad angeordnet sind, aber in der Ausgangskonfiguration weder direkt noch indirekt, d.h. über weitere Logikelemente, mit einem Ausgang bzw. einem Schnittstellen-Pin des programmierbaren Logikbausteins verbunden waren. Um die Zielkonfiguration weiterhin mit hohen FPGA-Taktraten betreiben zu können, werden bevorzugt freie Logikelemente in der Nähe (z.B. innerhalb einem definierten Radius) des jeweiligen Übergabepunkts verwendet. Dies vermeidet übermäßige Verzögerungen durch lange Signalpfade.

Eine Konfiguration des FPGA kann hierbei in mehreren Ebenen dargestellt werden. Auf unterster Ebene liegt ein die Konfiguration beschreibender Bitstrom vor, welcher direkt in den Konfigurationsspeicher des FPGA geschrieben werden kann. In der nächsthöheren Ebene liegt die Logikbeschreibung in Form einer platzierten Netzliste vor, bei der eine gewünschte Funktionalität bereits auf die Logik- und Verschaltungselemente abgebildet wurde und somit in einem Bitstrom übersetzt werden kann. Die nächsthöhere Ebene bildet eine Logikbeschreibung in Form einer unplatzierten Netzliste, bei der noch keine Abbildung auf konkrete Elemente des jeweiligen FPGA-Bausteins erfolgt ist. Je nach dem Vorgehen beim Erstellen der Konfiguration können noch höhere Abstraktionsebenen vorhanden sein, so kann eine Beschreibung der Konfiguration in einer Hardwarebeschreibungssprache wie VHDL oder SystemC vorliegen, welche anschließend in eine Netzliste konvertiert wird. Auch die Beschreibung in Form eines Blockdiagramms einer technischen Rechenumgebung wie Matlab und Simulink ist möglich, da z.B. mittels des Xilinx System Generators das Blockdiagramm in eine Darstellung der FPGA-Konfiguration in einer Hardwarebeschreibungssprache übersetzt werden kann. Hierbei kann es auch vorgesehen sein, dass anhand des Blockdiagramms automatisiert eine Liste möglicher Übergabepunkte erstellt wird, welche z.B. die den Ein- und Ausgänge eines Blocks bzw. eines Subsystems entsprechenden Logikelemente enthält.

Das Schreiben des geänderten Bitstroms kann vollständig oder differentiell erfolgen, wobei also vorzugsweise nur für geänderte Logikelemente oder Regionen ein geänderter Bitstrom geschrieben wird. Mit dem Schreiben des geänderten Bitstroms in den programmierbaren Logikbaustein ist insbesondere ein Beschreiben des Konfigurationsspeichers des programmierbaren Logikbausteins gemeint, wobei zweckmäßigerweise bei einem differentiellen Schreiben nur die Frames bzw. Adressbereiche des Konfigurationsspeichers beschrieben werden, welche ein oder mehrere umkonfigurierte oder zusätzliche Logikelemente oder Verbindungselemente umfassen. Hierbei kann es auch vorgesehen sein, einen nichtflüchtigen Speicher zu beschreiben, der bei einer Initialisierung des programmierbaren Logikbausteins ausgelesen wird und den Inhalt des Konfigurationsspeichers bestimmt; somit kann das Schreiben der geänderten Bitstroms in den programmierbaren Logikbaustein indirekt erfolgen.

Ein wichtiger Vorteil des erfindungsgemäßen Verfahrens liegt darin, dass kleine Änderungen an Logikfunktionen sehr schnell durchgeführt werden können, da nur die neu hinzugefügten Teile einer Logikfunktion platziert und geroutet werden müssen. Dies ermöglicht eine mit dem internen Bypassing vergleichbare Funktionalität auch für Steuergeräte, die einen FPGA umfassen. Somit kann eine Vielzahl von inkrementellen Änderungen mit geringem Zeitaufwand durchgeführt und getestet werden, was eine Beibehaltung des etablierten Workflows für den Regler-Entwurf gestattet.

Indem der Hersteller der Ausgangskonfiguration neben dem ursprünglichen Bitstrom auch relevante Struktur- bzw. Zuordnungsinformationen bereitstellt, können Änderungen an Logikfunktionen vorgenommen werden, ohne dass die gesamte Logikbeschreibung der Konfiguration offengelegt werden muss. Einerseits kann der Hersteller somit den detaillierten Source-Code geheim halten und andererseits Schnittstellen bereitstellen, die dem Anwender eine schnelle Anpassung bewährter Logikfunktionen ermöglichen.

Weiterhin ist es vorteilhaft, dass keine vorab implementierten Partitionsschnittstellen bzw. "virtual sockets" erforderlich sind; auch dadurch, dass keine Aufteilung in mehrere Partitionen mit entsprechenden Leerflächen erfolgt, können die vorhandenen Logik- und Verbindungselemente des FPGA-Bausteins effizient ausgenutzt werden.

Ein weiterer Vorteil besteht darin, dass durch die Anpassung des Programmier-Bitstroms, der vorzugsweise in einem nichtflüchtigen Speicher hinterlegt ist, eine gewünschte Funktionalität nach einem Neustart des Steuergeräts ohne Verzögerung unmittelbar zur Verfügung steht. Der für die Initialisierung des programmierbaren Logikbausteins verwendete nichtflüchtige Speicher kann über einen Mikrocontroller oder einen entsprechend konfigurierten zusätzlichen Logikbaustein wie einen CPLD ausgelesen werden, die zweckmäßigerweise mit dem programmierbaren Logikbaustein auf einer Leiterplatte angeordnet bzw. in dem Steuergerät integriert sind; prinzipiell kann der programmierbare Logikbaustein auch einen nichtflüchtigen Speicher umfassen.

Erfindungsgemäß werden auch die nicht mehr genutzten Logikelemente der Ausgangskonfiguration, deren Ausgänge nur mit einem oder mehreren Eingängen zumindest eines der Übergabepunkte verbunden sind, als frei markiert. Wenn also ein Ausgang eines Logikelements in der Ausgangskonfiguration mit einem Eingang eines Übergabepunkts verbunden ist bzw. war, aber der Eingang des Übergabepunkts in der Zielkonfiguration mit einem anderen Logikelement verbunden ist, so wird das Logikelement in der Zielkonfiguration nicht genutzt und kann als frei markiert werden. Durch ein derartiges Freigeben bzw. Bereinigen von nicht mehr benutzten Logikelementen wird die freie Fläche bzw. die Anzahl der für die Rekonfiguration verfügbaren Logikelemente maximiert.

Vorzugsweise werden weiterhin die entsprechenden Verbindungselemente als nicht genutzt markiert. Die entsprechenden Verbindungselemente umfassen hierbei insbesondere schaltbare Verbindungselemente, die in der Ausgangskonfiguration den Ausgang des als frei markierten Logikelements mit einer oder mehreren Leiterbahnen verbinden und diese Leiterbahn/en mit einem oder mehreren Eingängen eines oder mehrerer Übergabepunkte verbinden, sowie zweckmäßigerweise diese in der Zielkonfiguration unverbundene/n Leiterbahn/en. Das Freigeben von Logik- und Verbindungselementen ist besonders dann vorteilhaft, wenn die Ausgangskonfiguration die Ressourcen des FPGA-Bausteins nahezu vollständig ausfüllt.

In einer besonders bevorzugten Ausführungsform der Erfindung werden rekursiv alle Logikelemente, deren Ausgänge ausschließlich mit den Eingängen von in einem vorherigen Schritt als frei markierten Logikelementen verbunden sind, ebenfalls als frei markiert. Wenn der Ausgang eines Logikelements nur mit dem Eingang eines in einem vorherigen Schritt als frei markierten Logikelements verbunden ist, der Ausgabewert also verworfen würde, so wird das Logikelement nicht mehr genutzt und kann ebenfalls als frei markiert werden. Somit werden schrittweise alle nicht mehr benötigten Logikelemente und zweckmäßigerweise auch nicht mehr benötigte Verbindungselemente freigegeben.

Gemäß einer weiteren besonders bevorzugten Ausführungsform der Erfindung werden alle Logikelemente in einer vorgegebenen Region um ein oder mehrere ersetzte Logikelemente der Ausgangskonfiguration oder einen Eingang eines Übergabepunkts als frei markiert und die entsprechenden Verbindungselemente als ungenutzt markiert, wobei alle Logikelemente in der vorgegebenen Region mit Ausnahme des oder der ersetzten Logikelemente anschließend neu platziert und mit ungenutzten Verbindungselementen verbunden werden. Bei geeigneter Wahl der Region (z.B. anhand eines definierten Radius um den jeweiligen Übergabepunkt) kann somit auch eine Optimierung des Platzierens bzw. Routings stattfinden, wodurch bei nur geringer Zunahme der benötigten Entwurfszeit ein weitgehend optimales zeitliches Verhalten gewährleistet wird.

In einer ganz besonders bevorzugten Ausführungsform der Erfindung werden die in der Ausgangskonfiguration verwendeten Verbindungselemente, welche an einem der Logikelemente in der vorgegebenen Region enden, zumindest bis zu dem nächsten verbundenen Logikelement außerhalb der vorgegebenen Region als ungenutzt markiert. Somit wird sichergestellt, dass in der vorgegebenen Region hinreichend Verbindungselemente für ein optimiertes Routing verfügbar sind.

Zweckmäßigerweise umfasst der Schritt des Einlesens einer Ausgangskonfiguration das Einlesen eines Bitstroms und eine zumindest für Teile des Bitstroms vorgenommene Konvertierung des Bitstroms in eine Logikbeschreibung. Die Konvertierung kann insbesondere anhand von Architekturinformationen des verwendeten programmierbaren Logikbausteins erfolgen, wobei also eine Beziehung zwischen Position im Bitstrom und Logikelement auf dem programmierbaren Logikbaustein anhand von Architekturinformationen des verwendeten programmierbaren Logikbausteins hergestellt wird.

Es ist vorteilhaft, wenn der geänderte Bitstrom anhand der Zielkonfiguration erstellt wird, indem für die geänderten und somit zu rekonfigurierenden Logikelemente eine Beziehung zwischen Position im Bitstrom und Logikelement auf dem programmierbaren Logikbaustein hergestellt und der ursprüngliche Bitstrom an den entsprechenden Positionen geändert wird. Hierbei kann es vorgesehen sein, einen differentiellen Bitstrom zu erstellen, welcher nur die geänderten Logik- und Verbindungselemente beschreibt oder nur Adressbereiche umfasst, in denen mindestens ein geändertes Logikelement liegt. Wenn geeignete Architektur- bzw. Zuordnungsinformationen vorliegen, muss somit nur ein Minimum an Daten geschrieben werden.

Alternativ ist es vorteilhaft, wenn der geänderte Bitstrom anhand der Zielkonfiguration erstellt wird, indem die platzierte Netzliste der Zielkonfiguration in einen neuen vollständigen Bitstrom übersetzt wird. Wenn eine platzierte Netzliste der gesamten Zielkonfiguration vorliegt, ist eine schnelle Erstellung des geänderten Bitstroms möglich.

Bevorzugt wird für eine zu ändernde Logikfunktion, welche mindestens einen Signalpfad umfasst, zumindest nach der Änderung eine Signallaufzeit ermittelt. Vorzugsweise wird für einen Signalpfad in der Zielkonfiguration des programmierbaren Logikbausteins, in dessen Verlauf mindestens ein zusätzliches oder umkonfiguriertes Logikelement oder Verbindungselement vorkommt, eine Signallaufzeit geschätzt, indem die Anzahl sequentiell aufeinander folgender Logikelemente des Signalpfads in der Zielkonfiguration gezählt wird und jedem Logikelement eine konstante Signallaufzeit zugeordnet wird. Alternativ kann es auch vorgesehen sein, einen Signalpfad in der Zielkonfiguration des programmierbaren Logikbausteins, in dessen Verlauf mindestens ein zusätzliches oder umkonfiguriertes Logikelement vorkommt, mit dem entsprechenden Signalpfad in der Ausgangskonfiguration vergleichen, insbesondere indem die Anzahl sequentiell aufeinander folgender Logikelemente des Signalpfads in der Zielkonfiguration und die Anzahl sequentiell aufeinander folgender Logikelemente des entsprechenden Signalpfads in der Ausgangskonfiguration gezählt und verglichen wird und jedem Logikelement eine konstante Signallaufzeit zugeordnet wird. Auf diese Weise kann schnell und einfach festgestellt werden, ob die Zielkonfiguration voraussichtlich mit derselben Taktrate betrieben werden kann wie die Ausgangskonfiguration, oder ob eine Probleme in dem Zeitverhalten der Schaltung zu erwarten sind.

Besonders bevorzugt wird anstelle einer auf der Anzahl von Logikelementen im Signalpfad basierten Schätzung der Signallaufzeiten von Logikelementen die durch Architekturinformationen gegebenen minimalen und maximalen Signallaufzeiten ermittelt und für die weiteren Betrachtungen verwendet. Zweckmäßigerweise kann eine Summation von jeweils der minimalen und jeweils der maximalen Signallaufzeiten der einzelnen Logikelemente über einen Signalpfad erfolgen, und diese auf die Einhaltung von zeitlichen Anforderungen insbesondere der nachfolgenden Logikelemente überprüft werden.

Besonders bevorzugt wird für alle zu ändernden Logikfunktionen mindestens eine Signallaufzeit ermittelt und mit einem oder mehreren Schwellenwerten verglichen, der insbesondere zeitliche Anforderungen der auf die geänderte Logikfunktion folgenden Übergabepunkte beschreibt. Wenn die Änderung der geschätzten oder errechneten Verzögerung den Schwellenwert überschreitet, erfolgt eine Warnung und/oder eine Modifikation der platzierten Netzliste der Zielkonfiguration. Beispielsweise kann die Modifikation eine lokale Erhöhung des Takts und/oder ein Einfügen von Registern umfassen. Somit kann der Nutzer auf ein potentiell kritisches Zeitverhalten vorab hingewiesen werden und zweckmäßigerweise auch Maßnahmen ergriffen werden, um ein definiertes zeitliches Verhalten der Zielkonfiguration sicherzustellen.

Vorzugsweise umfasst die Zielkonfiguration mindestens einen ersten Multiplexer, der insbesondere direkt vor einem Übergabepunkt angeordnet ist, wobei alle hinzugefügten Logikelemente in neuen Signalpfaden angeordnet sind, die einen einzigen Eingang des ersten Multiplexers umfassen. Indem die Bypassfunktion mit einem ersten Eingang des Multiplexers verbunden wird und die bisherige Logikfunktion mit einem zweiten Eingang des Multiplexers verbunden wird, kann somit auch zur Laufzeit, also während die Zielkonfiguration ausgeführt wird, zwischen der Bypassfunktion und der ursprünglichen Funktion umgeschaltet werden. Hierbei kann ein freier Eingang eines vorhandenen Multiplexers genutzt werden oder der Multiplexer eingefügt werden.

Insbesondere umfassen die neuen Signalpfade mindestens ein Schnittstellen-Pin des programmierbaren Logikbausteins, wobei der mindestens eine Schnittstellen-Pin vorzugsweise einer Debugging-Schnittstelle des programmierbaren Logikbausteins zugeordnet ist. Der Schnittstellen-Pin muss dabei nicht exklusiv für den neuen Signalpfad genutzt werden, sondern kann auch weitere Funktionalitäten bereitstellen. Vorzugsweise wird ein Protokoll definiert, so dass die für den Signalpfad erforderlichen Daten über den Schnittstellen-Pin getunnelt werden. Insofern muss es sich bei diesem Schnittstellen-Pin nicht um einen physikalisch vorhandenen Pin handeln, sondern es kann sich auch um eine Schnittstelle bzw. einen Datenkanal handeln, der zweckmäßigerweise unter Nutzung der Debug-Schnittstelle aufgebaut wird. Sofern noch mindestens ein Schnittstellen-Pin des FPGA-Bausteins unbelegt ist bzw. in der Funktionalität ergänzt werden kann, kann also ein externes Bypassing stattfinden oder auch ein Multiplexer zum Umschalten zwischen verschiedenen internen Logikfunktionen von außen angesteuert werden. Die einer Debugging-Schnittstelle zugeordneten Schnittstellen-Pins sind selten mit anderen Funktionen belegt und somit häufig verfügbar. Falls ein oder mehrere andere Schnittstellen-Pins noch unbelegt sind, kann prinzipiell auch eine höhere Datenrate beim externen Bypassing gewährleistet werden, indem diese Schnittstellen-Pins für eine Übertragung nach einem geeigneten Protokoll wie z.B. LVDS verwendet werden.

Es ist vorteilhaft, wenn die Zielkonfiguration mindestens einen zweiten Multiplexer umfasst, der insbesondere direkt hinter einem Übergabepunkt angeordnet ist, wobei der zweite Multiplexer mit mindestens einem Eingang eines Logikelements verbunden ist. Dies ermöglicht es, die Eingabesignale einer Funktion zu ändern, wobei ggfs. die ursprüngliche Funktion mit dem geänderten Eingabesignal weiterverwendet werden kann.

Bevorzugt umfasst die Zielkonfiguration mindestens ein hinzugefügtes Register, wobei der Ausgang des Registers vorzugsweise mit einem Schnittstellen-Pin verbunden ist, welcher insbesondere einer Debugging-Schnittstelle des programmierbaren Logikbausteins zugeordnet ist. Indem das Register in einem Signalpfad angeordnet wird, kann das entsprechende Signal auch von einem RCP-System erfasst und ausgewertet werden, welches mit der Debugging-Schnittstelle verbunden ist.

Die Erfindung betrifft ferner ein Verfahren zum Anpassen eines Steuergeräts, welches einen zur Ausführung einer Regelfunktion eingerichteten programmierbaren Logikbaustein umfasst, bei dem der programmierbare Logikbaustein durch ein erfindungsgemäßes Verfahren rekonfiguriert wird. Durch die Nutzung eines erfindungsgemäßen Verfahrens können somit auch einen FPGA umfassende Steuergeräte schnell und einfach angepasst werden, so dass eine iterative Entwicklung der neuen Regelfunktion möglich ist. Mit dem Begriff Regelfunktion sind hier zweckmäßigerweise alle von dem Steuergerät bzw. dem programmierbaren Logikbaustein bereitgestellten Funktionen gemeint, insbesondere auch eine Ansteuerung eines Aktuators ohne geschlossene Regelschleife.

Zweckmäßigerweise erfolgt zumindest der Schritt des Schreibens eines geänderten Bitstroms in den programmierbaren Logikbaustein bei der Initialisierung des programmierbaren Logikbausteins, und wird insbesondere von einem Mikroprozessor durchgeführt. Somit ist die angepasste Logikfunktion bzw. die Bypassfunktion direkt zum Startzeitpunkt des FPGAs bzw. des den FPGA umfassenden Steuergeräts verfügbar.

Außerdem betrifft die Erfindung eine Programmiervorrichtung zum Beschreiben eines programmierbaren Logikbausteins, umfassend einen Prozessor, eine Programmierschnittstelle und/oder eine Debugging-Schnittstelle, wobei die Vorrichtung dazu eingerichtet ist, ein erfindungsgemäßes Verfahren durchzuführen.

Die Erfindung betrifft weiterhin ein Computerprogrammprodukt mit einem computerlesbaren Speichermedium, auf dem Befehle eingebettet sind, die, wenn sie von einer Recheneinheit ausgeführt werden, bewirken, dass die Recheneinheit dazu eingerichtet ist, ein erfindungsgemäßes Verfahren auszuführen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Abmessungen sind nicht maßstäblich und weisen, sofern nicht anders angegeben auch keine ableitbaren geometrischen Relationen zueinander auf.

Darin zeigt:
- Figur 1: einen schematischen Ablaufplan eines ersten bevorzugten Ausführungsform eines erfindungsgemäßen Verfahrens,
- Figur 2a: eine schematische Darstellung einer geänderten Konfiguration eines programmierbaren Logikbausteins,
- Figur 2b: einen schematische Darstellung einer zweiten bevorzugten Ausführungsform einer erfindungsgemäßen Verfahrens,
- Figur 3: eine schematische Ansicht auf einen programmierbaren Logikbaustein, der mit einem erfindungsgemäßen Verfahren rekonfiguriert werden kann, und
- Figur 4: eine schematische Ansicht eines Steuergeräts mit einem programmierbaren Logikbaustein und eine erfindungsgemäße Programmiervorrichtung.

Ein FPGA-Baustein umfasst eine Vielzahl von Logikelementen und Verbindungselementen sowie eine Taktversorgung, welche mehrere Taktregionen umfassen kann. Die Logikelemente umfassen beispielsweise Register, Wahrheitstabellen (auch als Lookup-Table bzw. LUT bekannt), Addierer, Schalter und Verzögerungseinheiten. Auch Frequenzgeneratoren können vorhanden sein. Je nach Granularität des FPGA-Bausteins können auch mehrere dieser Elemente zu einer Elementar-Einheit zusammengefasst sein. Die Verbindungselemente umfassen zweckmäßigerweise Leiterbahnen unterschiedlicher Länge, welche z.B. auch Regionen des FPGA überspannen können, und schaltbare Verbindungen zwischen den Leiterbahnen und Logikelementen. Nach dem Einschalten der Spannungsversorgung wird der FPGA mit einem Bitstrom initialisiert, der zweckmäßigerweise für jedes Logikelement mindestens ein Bit enthält; dies ermöglicht eine für die jeweilige Anwendung maßgeschneiderte Logikschaltung auf einem Standard-Baustein. Unter einem Bit für die Konfiguration eines Logikelements kann hierbei auch ein Schalter verstanden werden, der das Logikelement mit einem Signal verbindet. In diesem Sinne können auch einem UND-Gatter ein oder mehrere Konfigurations-Bits zugeordnet werden.

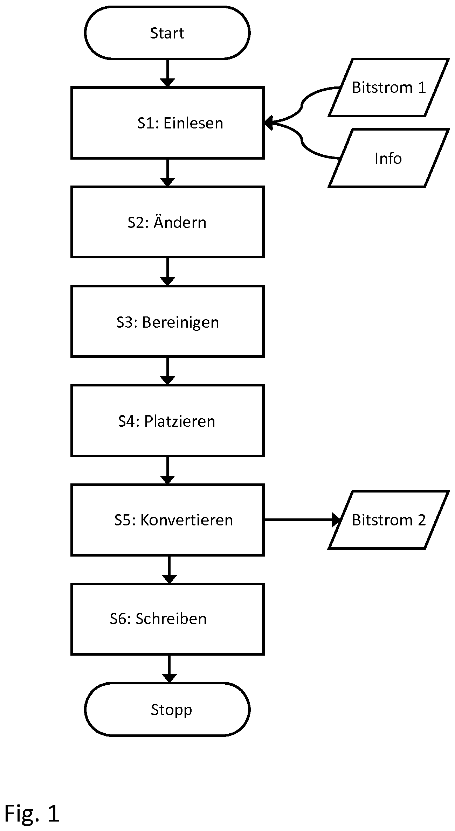

Die Abbildung der Figur 1 zeigt einen schematischen Ablaufplan einer ersten bevorzugten Ausführungsform eines erfindungsgemäßen Verfahrens.

In Schritt S1 (Einlesen) erfolgt ein Einlesen der Ausgangskonfiguration, wobei als Eingangsdaten der ursprüngliche Bitstrom (Bitstrom 1) und Informationen (Info) über die Architektur des verwendeten FPGA-Bausteins und die Ausgangskonfiguration empfangen werden. Das Einlesen kann ein Konvertieren des Bitstroms in eine Logikbeschreibung bzw. platzierte Netzliste der Ursprungskonfiguration umfassen. Alternativ kann es auch vorgesehen sein, als Eingangsdaten neben dem Bitstrom auch eine Logikbeschreibung zumindest von Teilen der Ausgangskonfiguration sowie Informationen über mögliche Eingangssignale und mögliche Übergabepunkte der Ausgangskonfiguration zum empfangen. Dann kann auf ein Konvertieren des Bitstroms verzichtet werden.

Die in der Zielkonfiguration gewünschten Änderungen werden in Schritt S2 (Ändern) vorzugsweise auf einer höheren Abstraktionsebene wie der Logikbeschreibung bzw. einer unplatzierten Netzliste vorgenommen. Prinzipiell könnte auch eine Hardwarebeschreibungs-Sprache wie VHDL zur Angabe der Zielkonfiguration bzw. der gewünschten Änderungen eingesetzt werden.

Beispielsweise kann der Nutzer neue Eingangssignale wählen und eine angepasste Logikfunktion an dem jeweiligen Übergabepunkt anlegen. Diese Änderung der Konfiguration kann auch interaktiv in einem Programm vorgenommen werden, dass auf einem an den FPGA-Baustein bzw. an das Steuergerät angeschlossenen Standard-PC und/oder einem speziellen Programmiergerät ausgeführt; auch ein Standard-PC mit extern angeschlossener Debugging-Schnittstelle, die mit einem FPGA verbindbar ist, soll unter der Bezeichnung Programmiervorrichtung verstanden werden können.

Ein derartiges Programm, im Folgenden FPGA-Manager genannt, könnte z.B. die Zuordnungsinformationen des Konfigurationsherstellers, zweckmäßigerweise Architekturinformationen des verwendeten FPGA-Bausteins sowie zumindest eine Logikbeschreibung, insbesondere eine platzierte Netzliste, und/oder einen Bitstrom der Ausgangskonfiguration einlesen. Es ist vorteilhaft, wenn der FPGA-Manager dazu eingerichtet ist, die Ausgangskonfiguration zumindest teilweise in einer höheren Abstraktionsebene, wie einer Logikbeschreibung einer unplatzierten Netzliste oder einem Blockdiagramm darzustellen. Dann kann der Nutzer eine oder mehrere Elementareinheiten der jeweiligen Abstraktionsebene selektieren und anpassen. Zweckmäßigerweise ist auch das Löschen oder Einfügen von Elementareinheiten vorgesehen. Die Elementareinheiten können eine oder mehrere Logikeinheiten des FPGA-Bausteins umfassen. Beispielsweise kann auch eine häufig verwendete Funktionalität aus einer Mehrzahl von Logikeinheiten des FPGA als eine Elementareinheit vordefiniert werden. Vorzugsweise kann der Nutzer weiterhin vordefinierte Übergabepunkte und/oder Schnittstellen-Pins des FPGA selektieren, um diesen die Signale der geänderten Logikfunktionen zuzuführen. Auch eine Überprüfung vorgegebener Bedingungen kann vorgesehen sein, wobei insbesondere ein gesondertes Signal über eine Debugging-Schnittstelle ausgegeben werden kann, wenn die vorgegebenen Bedingungen nicht erfüllt sind. Somit kann eine fehlerhaft definierte Logikfunktion oder ungültige Eingabedaten schnell erkannt werden.

In Schritt S3 (Bereinigen) werden zweckmäßigerweise nicht mehr genutzte Logikelemente aus der Ausgangskonfiguration entfernt, um eine größere Anzahl von freien Logikelementen zur Realisierung der geänderten Logikfunktionen verfügbar zu machen.

Der FPGA Manager kann hierbei auch vorsehen, die nicht mehr genutzten Logikelemente anhand der gelöschten Elementareinheiten zu ermitteln.

Auf die freien Logikelemente werden in Schritt S4 (Platzieren) die in der Zielkonfiguration hinzugekommenen Logikfunktionen bzw. Logikelemente platziert. Anschließend werden die Verbindungselemente konfiguriert, um die gewünschten Signalpfade zu erhalten. Somit liegt die Zielkonfiguration als platzierte Netzliste vor.
Im Rahmen des Platzierens und des Verbinden der Logikfunktionen bzw. Logikelemente werden dabei zweckmäßigerweise Anforderungen bezüglich des Timings wie z.B. das Einhalten geforderter Signallaufzeiten zum Erreichen von vorgegebenen Taktfrequenzen berücksichtigt.

Der FPGA Manager kann hierbei auch vorsehen, hinzugekommene Logikelemente anhand der hinzugefügten Elementareinheiten zu ermitteln.

In Schritt S5 (Konvertieren) wird die platzierte Netzliste in einen geänderten Bitstrom konvertiert, der somit als Ausgabedaten (Bitstrom 2) zur Verfügung steht.

Besonders wenn die Logikbeschreibung der Ausgangskonfiguration nur teilweise vorhanden ist, kann die Konvertierung auch darin bestehen, für hinzugekommene Logikeinheiten und/oder Verbindungseinheiten geeignete Mikrobitströme zu generieren und diese zum ursprünglichen Bitstrom zu addieren, um den geänderten Bitstrom zu erhalten.

Der FPGA-Baustein wird in Schritt S6 (Schreiben) mit dem geänderten Bitstrom beschrieben und somit rekonfiguriert. Da ein zeitraubendes Platzieren und Routen nur für die wenigen geänderten Logikelemente erfolgte, kann diese Rekonfiguration schnell erfolgen und ist prinzipiell auch ohne eine Kenntnis der vollständigen Netzliste möglich.

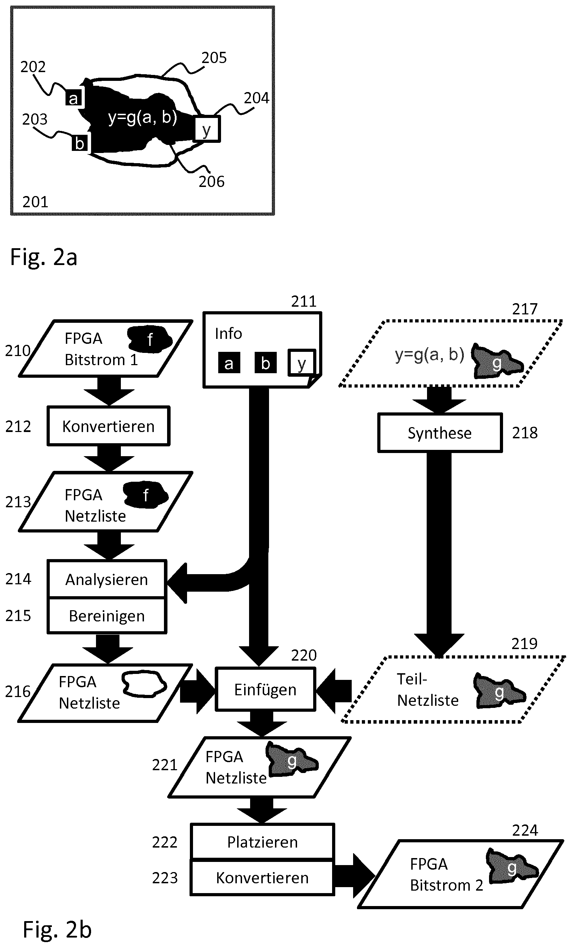

In der Abbildung der Figur 2a ist eine geänderte Konfiguration eines programmierbaren Logikbausteins schematisch dargestellt.

Die Konfiguration 201 umfasst zwei Übergabepunkte 202 und 203, welche Eingangssignale a und b bereitstellen, sowie einen Übergabepunkt 204, an den das Funktionsergebnis y angelegt wird. Die Übergabepunkte werden vorzugsweise vom Nutzer mittels des FPGA-Managers festgelegt oder können anhand einer vom Hersteller der ursprünglichen Konfiguration bereitgestellten Liste möglicher Übergabepunkte manuell oder automatisch ausgewählt werden.

Schematisch ist dargestellt, dass der von der ursprünglichen Logikfunktion f eingenommene Bereich 205 freigegeben wurde, und dass die hinzugefügte Logikfunktion y=g(a,b) in einem Bereich 206 unter Verwendung freier bzw. ungenutzter Logik- und Verbindungselemente implementiert ist, so dass der Außenbereich der Konfiguration 201 von der Änderung unberührt bleibt.

Die Abbildung der Figur 2b zeigt eine schematische Darstellung einer zweiten bevorzugten Ausführungsform eines erfindungsgemäßen Verfahrens.

Zu Beginn des Verfahrens werden die ursprüngliche Konfiguration 210 des FPGA und Zuordnungsinformationen 211 eingelesen. Die Ausgangskonfiguration in FPGA Bitstrom 1 umfasst eine Logikfunktion y=f(a,b), welche ersetzt werden soll. Als Info hierzu sind die zwei Übergabepunkte angegeben, an denen die Eingangssignale a und b anliegen, sowie der Übergabepunkt, an dem der Funktionswert y angelegt werden soll. Abhängig von dem verwendeten FPGA-Baustein kann Bitstrom 210 einerseits eine feste Zuordnung zwischen Position und Logikelement aufweisen oder andererseits eine Liste von Adresse/Konfigurations-Paaren umfassen. Somit kann prinzipiell ausgehend von einer Start-Adresse ein ganzer Adressbereich (oder der ganze FPGA) neu geschrieben werden, oder die Logikelemente einzeln umkonfiguriert werden.

In Schritt 212 erfolgt das Konvertieren des Bitstroms 210 in eine platzierte Netzliste 213. Die platzierte Netzliste 213 wird unter Verwendung von den angegebenen Übergabepunkten und zweckmäßigerweise Architekturinformationen des FPGAs in Schritt 214 analysiert, woraufhin in Schritt 215 ein Bereinigen stattfindet, bei dem nicht verwendete Logik- und Verschaltungselemente als frei bzw. ungenutzt markiert werden. Die bereinigte FPGA Netzliste 216 weist somit freie Logikelemente bzw. Bereich auf, welche für die Realisierung der neuen Funktion verwendet werden können.

Die neue Logikfunktion 217, welche insbesondere mittels eine Blockdiagramms beschrieben werden kann, basiert vorzugsweise auf denselben Eingabesignalen a, b wie die Ursprungsfunktion und gibt einen geänderten Wert y=g(a,b) aus. In Schritt 218 erfolgt daher eine Synthese der geänderten Logikfunktion, d.h. die Logikbeschreibung der Teilfunktion wird in eine unplatzierte Teil-Netzliste 219 konvertiert.

Ausgehend von den Informationen 211 über die Übergabepunkte, wird in Schritt 220 ein Einfügen der Teil-Netzliste 219 in die bereinigte FPGA-Netzliste 216 vorgenommen, so dass eine die vollständige Konfiguration beschreibende Netzliste 221 entsteht.

Die noch unplatzierten neuen Logikfunktion 217 wird in Schritt 222 auf die freien Logikelemente platziert und diese mit ungenutzten Verbindungselementen geroutet. In Schritt 223 erfolgt ein Konvertieren der vollständigen Netzliste in einen neuen Bitstrom 224. Somit liegt ein die Zielkonfiguration beschreibender vollständiger FPGA Bitstrom 2 vor, der direkt oder indirekt in einen programmierbaren Logikbaustein geschrieben werden kann.

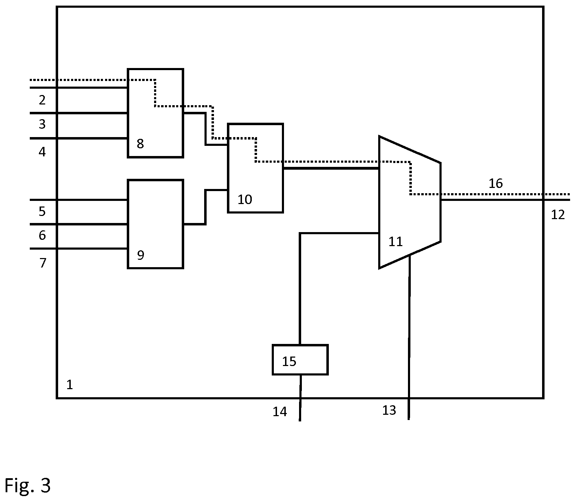

In der Abbildung der Figur 3 ist ein programmierbarer Logikbaustein 1 schematisch dargestellt. Über Schnittstellen-Pins 2, 3, 4, 5, 6, 7 werden dem FPGA 1 Eingangssignale zugeführt. Die dargestellte Beispielkonfiguration weist mehrere vereinfacht dargestellte Funktionsblöcke auf, die prinzipiell aus einer Reihe elementarer Logikeinheiten wie Wahrheitstabellen und Flip-Flops aufgebaut sind. Die an den Schnittstellen-Pins 2, 3, 4 anliegenden Eingangssignale werden beispielsweise Funktionsblock 8 zugeführt, der eine erste Logikfunktion berechnet. Entsprechend werden die an den Schnittstellen-Pins 5, 6, 7 anliegenden Eingangssignale Funktionsblock 9 zugeführt, der eine zweite Logikfunktion berechnet. Die Signale der Funktionsblöcke 8 und 9 werden einem weiteren Funktionsblock 10 zugeführt, der eine dritte Logikfunktion berechnet. Über Multiplexer 11 kann das Funktionsergebnis der dritten Logikfunktion einem Schnittstellen-Pin 12 des programmierbaren Logikbausteins 1 zugeführt werden und wird somit als Ausgangssignal ausgegeben. Als gestrichelte Linie ist ein beispielgemäßer Signalpfad 16 dargestellt. Die gezeigte Logikfunktion, deren Ausgangssignal an Schnittstellen-Pin 12 ausgegeben wird, umfasst somit 6 Signalpfade, die jeweils an einem der Schnittstellen-Pins 2, 3, 4, 5, 6, 7 beginnen.

Indem einer der Funktionsblöcke 8, 9 oder 10 geändert oder ersetzt wird, kann die ausgegebene Logikfunktion modifiziert werden. Alternativ zu einem vollständigen Austausch der ursprünglichen Logikfunktion kann auch ein Umschalten ermöglicht werden, indem die ursprüngliche Logikfunktion beibehalten und eine geänderte Logikfunktion in der Konfiguration integriert wird, sowie am Ausgang des entsprechenden Funktionsblocks ein Multiplexer angeordnet wird. Darüber hinaus kann auch eine Vorverarbeitung der Eingabesignale einer Logikfunktion eingefügt werden. Insbesondere ist es möglich, eine zusätzliche Logikfunktion zu integrieren, die einen Wahrheitswert zur Gültigkeit der Eingabesignale in Abhängigkeit von einer oder mehreren Bedingungen ausgibt. Auch ein Einfügen zusätzlicher Register zum Beibehalten konsistenter Daten kann erfolgen. Wenn der FPGA 1 in einem Steuergerät eingesetzt wird, kann somit ein internes Bypassing vorgenommen werden.

Indem ein weiterer Eingang des benachbart zu Ausgangspin 12 angeordneten Multiplexers 11 mit einem über einen weiteren Schnittstellen-Pin 14 verbunden wird, kann auch ein externes Signal an Schnittstellen-Pin 12 ausgegeben werden. Zur Vermeidung von Synchronisationsproblemen ist es zweckmäßig, wenn das Signal von Schnittstellen-Pin 14 einem Register 15 zugeführt wird, so dass immer ein definiertes Signal an Multiplexer 11 anliegt. Über Schnittstellen-Pin 13 kann der gewünschte Eingang von Multiplexer 11 selektiert und somit das in Signalpfad 16 angeordnete Ausgangssignal geändert werden. Es ist vorteilhaft, wenn die Schnittstellen-Pins 14 und 13 einer Debugging-Schnittstelle wie JTAG zugeordnet sind, da diese Pins im Allgemeinen nicht belegt sind und/oder über diese Debugging-Schnittstelle, zweckmäßigerweise unter Erweiterung der vorhandene Debugging-Funktions-Protokolle, Signale in den FPGA hinein- oder heraus übertragen werden können. Wird der FPGA 1 in einem Steuergerät eingesetzt, dann ist somit auch ein externes Bypassing möglich.

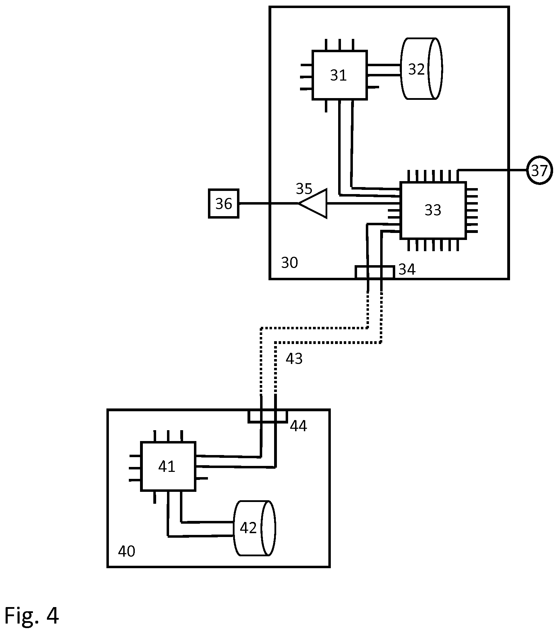

Die Abbildung der Figur 4 zeigt eine schematische Ansicht eines Steuergeräts 30 mit einem programmierbaren Logikbaustein 33 und eine erfindungsgemäße Programmiervorrichtung 40.

Steuergerät 30 umfasst einen Mikrocontroller 31, der mit einem nichtflüchtigen Speicher 32, insbesondere einem Flash-Speicher, und mit dem FPGA 33 verbunden ist. Mikrocontroller 31 kann auch noch mit einem oder mehreren nicht gezeigten Schnittstellen, insbesondere für einen Fahrzeugdatenbus, und/oder weiterer Peripherie verbunden sein.

Der programmierbare Logikbaustein 33 stellt vorzugsweise eine Regelfunktion bereit und ist in dem gezeigten Beispiel mit einem Sensor 37 und einer Ansteuerschaltung 35 verbunden, die einen Aktor 36 ansteuert. Weiterhin weist FPGA eine Programmier- und/oder Debugging-Schnittstelle 34 auf.

Normalerweise ist Programmierschnittstelle 34 nicht verbunden, und das Steuergerät stellt eine oder mehrere Regelfunktionen bereit; beispielsweise kann Aktor 36 ein bürstenloser Elektromotor sein, dessen Drehzahl und/oder abgegebenes Drehmoment von dem programmierbaren Logikbaustein 33 geregelt wird.

Programmiervorrichtung 40 umfasst einen Mikrocontroller 41, der mit einem nichtflüchtigen Speicher 42, insbesondere einem Flash-Speicher und einer Programmier- und/oder Debugging-Schnittstelle 44 verbunden ist.

Über gestrichelt dargestellte Verbindungsleitungen 43 kann die Programmiervorrichtung 40 mit dem Steuergerät 30 bzw. dem darauf angeordneten FPGA 33 verbunden werden. Indem der programmierbare Logikbaustein 33 umkonfiguriert wird, kann daher die Regelfunktion mit geringem Aufwand angepasst werden.

Prinzipiell kann ein Ändern der Konfiguration auch dadurch erfolgen, dass das Programmiergerät mit dem Mikrocontroller 31 oder dem nichtflüchtigen Speicher 32 verbunden ist und die geänderte Konfiguration zunächst in den nichtflüchtigen Speicher 32 und erst indirekt in den programmierbaren Logikbaustein 33 geschrieben wird. Dies hat den Vorteil, dass die geänderte Konfiguration auch bei jeder weiteren Initialisierung des Steuergeräts 30 sofort verfügbar ist.

Die in der Abbildung gezeigte Nutzung der Debugging-Schnittstelle 34 hat den Vorteil, dass diese ein Umschalten zwischen verschiedenen Logik- bzw. Regelfunktionen im laufenden Betrieb des Steuergeräts ermöglicht. Zu diesem Zweck kann in der geänderten Konfiguration beispielsweise direkt vor dem mit Ansteuerschaltung 35 verbundenen Schnittstellen-Pin des FPGA 33 ein Multiplexer angeordnet werden, wobei ein erster Eingang des Multiplexers vorzugsweise mit der ursprünglichen Regelfunktion verbunden ist und ein zweiter Eingang des Multiplexers mit einer geänderten Regelfunktion verbunden ist.

Besonders bevorzugt erfolgt die Wahl des durchzuschaltenden Eingangs über ein mit dem Umschalteingang verbundenes Register, so dass der Inhalt des Registers die aktive Regelfunktion bestimmt. Indem ein Datenkanal über die Debugging-Schnittstelle 34 eingerichtet wird, kann der Inhalt des Registers vom Programmiergerät 40 beschrieben werden. Somit kann der Nutzer über Programmiergerät 40 zwischen verschiedenen Regelfunktionen umschalten. Dies beschleunigt den Entwurf neuer Steuergeräte bzw. Regelfunktionen weiter.

In einer weiteren bevorzugten Ausführungsform der Erfindung wird ein Register in einem Signalpfad der Ausgangskonfiguration angeordnet, wobei der Ausgang des Registers zweckmäßigerweise mit einem der Debugging-Schnittstelle zugeordneten Pin des FPGA verbunden ist. Somit erfasst das Register ein Signal der Ausgangskonfiguration und kann dieses an ein externes RCP-System übertragen. Indem eine Trigger-Logik hinzugefügt wird, kann der Zeitpunkt der Erfassung anhand einer Auswertung vorgegebener Bedingungen bestimmt werden. Alternativ oder ergänzend kann auch vorgesehen sein, das Signal auf dem programmierbaren Logikbaustein zwischenzuspeichern. Durch das erfindungsgemäße Verfahren ist es somit möglich, auch ohne Vorliegen des Quellcodes bzw. einer vollständigen Logikbeschreibung der Ausgangskonfiguration eine Messfunktionalität hinzuzufügen.

## Patentansprüche

1. Verfahren zum Ändern der Konfiguration eines programmierbaren Logikbausteins, bei dem eine Ausgangskonfiguration (210) des programmierbaren Logikbausteins eingelesen wird, so dass eine Logikbeschreibung, insbesondere eine platzierte Netzliste, der Ausgangskonfiguration zumindest teilweise vorliegt, wobei aus der Logikbeschreibung der Ausgangskonfiguration des programmierbaren Logikbausteins ein oder mehrere Logikelemente und/oder Verbindungselemente ersetzt oder umkonfiguriert werden und eine Logikbeschreibung einer Zielkonfiguration erstellt wird, welche ein oder mehrere zusätzliche Logikelemente aufweist, wobei kein, ein oder mehrere Elemente der Ausgangskonfiguration in der Zielkonfiguration nicht genutzt werden, wobei aus der Logikbeschreibung der Zielkonfiguration ein geänderter Bitstrom erstellt wird und wobei der geänderte Bitstrom in den programmierbaren Logikbaustein geschrieben wird, **dadurch gekennzeichnet, dass** anhand von Zuordnungsinformationen (211) Übergabepunkte bestimmt werden, also in Ziel- und Ausgangskonfiguration vorhandenen Logikelemente, insbesondere Register oder Treiber, an denen in der Zielkonfiguration eine geänderte Logikfunktion angelegt wird (212, 213), wobei die bereits in der Ausgangskonfiguration nicht genutzten Logikelemente des programmierbaren Logikbausteins als frei markiert werden (214, 215), wobei auch die nicht mehr genutzten Logikelemente der Ausgangskonfiguration, deren Ausgänge nur mit Eingängen von Übergabepunkten verbunden sind, als frei markiert werden (216), und wobei die zusätzlichen Logikelemente der Zielkonfiguration auf den als frei markierten Logikelementen platziert und über ungenutzte Verbindungselemente mit den Übergabepunkten verbunden werden.

2. Verfahren nach Anspruch 1, **dadurch gekennzeichnet, dass** die entsprechenden Verbindungselemente von den nicht mehr genutzten Logikelementen als ungenutzt markiert werden.

3. Verfahren nach Anspruch 1 oder 2, **dadurch gekennzeichnet, dass** rekursiv alle Logikelemente, deren Ausgänge ausschließlich mit einem oder mehreren Eingängen von in einem vorherigen Schritt als frei markierten Logikelementen verbunden sind, ebenfalls als frei markiert werden, wobei vorzugsweise die entsprechenden Verbindungselemente als ungenutzt markiert werden.

4. Verfahren nach einem der vorhergehenden Ansprüche, **dadurch gekennzeichnet, dass** alle Logikelemente in einer vorgegebenen Region um ein oder mehrere ersetzte Logikelemente der Ausgangskonfiguration oder einen Eingang eines Übergabepunkts als frei markiert und die entsprechenden Verbindungselemente als ungenutzt markiert werden, wobei alle Logikelemente in der vorgegebenen Region mit Ausnahme des oder der ersetzten Logikelemente anschließend neu platziert und mit ungenutzten Verbindungselementen verbunden werden.

5. Verfahren nach Anspruch 4, **dadurch gekennzeichnet, dass** die in der Ausgangskonfiguration verwendeten Verbindungselemente, welche an einem der Logikelemente in der vorgegebenen Region enden, zumindest bis zu dem nächsten verbundenen Logikelement außerhalb der vorgegebenen Region als ungenutzt markiert werden.

6. Verfahren nach einem der vorhergehenden Ansprüche, **dadurch gekennzeichnet, dass** der Schritt des Einlesens einer Ausgangskonfiguration das Einlesen eines Bitstroms und eine zumindest für Teile des Bitstroms vorgenommene Konvertierung des Bitstroms in eine Logikbeschreibung umfasst, wobei die Konvertierung insbesondere anhand von Architekturinformationen des verwendeten programmierbaren Logikbausteins erfolgt.

7. Verfahren nach einem der vorhergehenden Ansprüche, **dadurch gekennzeichnet, dass** der geänderte Bitstrom anhand der Zielkonfiguration erstellt wird, indem für die geänderten und somit umkonfigurierten Logikelemente und/oder Verbindungselemente eine Beziehung zwischen Position im Bitstrom und Logikelement oder Verbindungselement auf dem programmierbaren Logikbaustein hergestellt und der ursprüngliche Bitstrom an den entsprechenden Positionen geändert wird.

8. Verfahren nach einem der Ansprüche 1 bis 6, **dadurch gekennzeichnet, dass** der geänderte Bitstrom anhand der Zielkonfiguration erstellt wird, indem die platzierte Netzliste der Zielkonfiguration in einen neuen vollständigen Bitstrom übersetzt wird.

9. Verfahren nach einem der vorhergehenden Ansprüche, **dadurch gekennzeichnet, dass** für eine zu ändernde Logikfunktion, welche mindestens einen Signalpfad umfasst, zumindest nach der Änderung eine Signallaufzeit ermittelt wird, wobei vorzugsweise für einen Signalpfad in der Zielkonfiguration des programmierbaren Logikbausteins, in dessen Verlauf mindestens ein zusätzliches oder umkonfiguriertes Logikelement oder Verbindungselement vorkommt, eine Signallaufzeit geschätzt wird, indem die Anzahl sequentiell aufeinander folgender Logikelemente des Signalpfads in der Zielkonfiguration gezählt wird und jedem Logikelement eine konstante Signallaufzeit zugeordnet wird.

10. Verfahren nach einem der vorhergehenden Ansprüche **dadurch gekennzeichnet, dass** für alle zu ändernden Logikfunktionen und/oder alle von diesen umfassten Signalpfade mindestens eine Signallaufzeit ermittelt und mit einem oder mehreren Schwellenwerten verglichen wird, und dass eine Warnung und/oder eine Modifikation der platzierten Netzliste der Zielkonfiguration erfolgt, wenn mindestens eine ermittelte Signallaufzeit den Schwellenwert überschreitet oder außerhalb eines vorgegebenen Intervalls liegt.

11. Verfahren nach einem der vorhergehenden Ansprüche, **dadurch gekennzeichnet, dass** die Zielkonfiguration mindestens einen ersten Multiplexer umfasst, der insbesondere direkt vor einem Übergabepunkt angeordnet ist, und dass alle hinzugefügten Logikelemente in neuen Signalpfaden angeordnet sind, die einen einzigen Eingang des ersten Multiplexers umfassen.

12. Verfahren nach Anspruch 11, **dadurch gekennzeichnet, dass** die neuen Signalpfade mindestens ein Schnittstellen-Pin des programmierbaren Logikbausteins umfassen, wobei der mindestens eine Schnittstellen-Pin vorzugsweise einer Debugging-Schnittstelle des programmierbaren Logikbausteins zugeordnet ist.

13. Verfahren nach einem der vorhergehenden Ansprüche, **dadurch gekennzeichnet, dass** die Zielkonfiguration mindestens einen zweiten Multiplexer umfasst, der insbesondere direkt hinter einem Übergabepunkt angeordnet ist, wobei der zweite Multiplexer mit mindestens einem Eingang eines Logikelements verbunden ist.

14. Verfahren nach einem der vorhergehenden Ansprüche, **dadurch gekennzeichnet, dass** die Zielkonfiguration mindestens ein hinzugefügtes Register umfasst, wobei der Ausgang des Registers vorzugsweise mit einem Schnittstellen-Pin verbunden ist, welcher insbesondere einer Debugging-Schnittstelle des programmierbaren Logikbausteins zugeordnet ist.

15. Verfahren zum Anpassen eines Steuergeräts, welches einen zur Ausführung einer Regelfunktion eingerichteten programmierbaren Logikbaustein umfasst, bei dem die Konfiguration des programmierbaren Logikbausteins durch ein Verfahren nach einem der vorhergehenden Ansprüche verändert wird.

16. Programmiervorrichtung zum Beschreiben eines programmierbaren Logikbausteins, umfassend einen Prozessor, eine Programmierschnittstelle und/oder eine Debugging-Schnittstelle, wobei die Vorrichtung dazu eingerichtet ist, ein Verfahren nach einem der Ansprüche 1 bis 15 auszuführen.

17. Computerprogrammprodukt mit einem computerlesbaren Speichermedium, auf dem Befehle eingebettet sind, die, wenn sie von einer Recheneinheit ausgeführt werden, bewirken, dass die Recheneinheit dazu eingerichtet ist, ein Verfahren gemäß einem der Ansprüche 1 bis 15 auszuführen.

## Claims

1. A method for modifying the configuration of a programmable logic device, an initial configuration (210) of the programmable logic device being read in so that a logic description, particularly a placed netlist, is at least partially present, one or more logic elements and/or connecting elements being replaced or reconfigured from the logic description of the initial configuration of the programmable logic device and a logic description of a target configuration comprising one or more additional logic elements being produced, and none, one, or more of the elements of the initial configuration not being used in the target configuration, a modified bitstream being produced from the logic description of the target configuration, and the modified bitstream being written to the programmable logic device, **characterized in that** transfer points are determined using association information (211), that is, logic elements present in the target and initial configurations, particularly registers or drivers, at which a modified logic function is placed (212, 213) in the target configuration, wherein the logic elements of the programmable logic device already not used in the initial configuration are marked as free (214, 215), wherein the logic elements of the initial configuration, having outputs connected only to inputs of transfer points, are also marked as free (216), and wherein the additional logic elements of the target configuration are placed on the logic elements marked as free and connected to the transfer points by means of unused connecting elements.

2. The method according to claim 1, **characterized in that** the corresponding connecting elements of the no longer used logic elements are marked as unused.

3. The method according to claim 1 or 2, **characterized in that** all logic elements having outputs exclusively connected to one or more inputs of logic elements marked as free in a previous step are also marked as free, wherein the corresponding connecting elements are preferably marked as unused.

4. The method according to any one of the preceding claims, **characterized in that** all logic elements in a defined region around one or more replaced logic elements of the initial configuration or around an input of a transfer point are marked as free and the corresponding connecting elements are marked as unused, wherein all logic elements in the defined region, with the exception of the replaced logic elements, are then newly placed and connected to unused connecting elements.

5. The method according to claim 4, **characterized in that** the connecting elements used in the initial configuration and ending at one of the logic elements in the defined region are marked as unused, at least up to the next connected logic element outside of the defined region.

6. The method according to any one of the preceding claims, **characterized in that** the step of reading an initial configuration comprises reading a bitstream and converting the bitstream into a logic description, at least for parts of the bitstream, wherein the converting takes place particularly using architecture information of the programmable logic device used.

7. The method according to any one of the preceding claims, **characterized in that** the modified bitstream is produced using the target configuration, **in that** a relationship between position in the bitstream and logic element or connecting element on the programmable logic device is produced for the modified and thus reconfigured logic elements and/or connecting elements, and the original bitstream is modified at the corresponding positions.

8. The method according to any one of the claims 1 through 6, **characterized in that** the modified bitstream is produced using the target configuration, **in that** the placed netlist of the target configuration is translated into a new, complete bitstream.

9. The method according to any one of the preceding claims, **characterized in that** a signal propagation time is calculated at least after the modification for a logic function to be modified and comprising at least one signal path, wherein a signal propagation time is preferably estimated for a signal path in the target configuration of the programmable logic device in the path of which at least one additional or reconfigured logic element or connecting element is present, **in that** the quantity of sequentially successive logic elements of the signal path in the target configuration is counted and a constant signal propagation time is associated with each logic element.

10. The method according to any one of the preceding claims, **characterized in that** at least one signal propagation time is calculated for all logic functions to be modified and/or for all signal paths comprised by the same, and is compared with one or more threshold values, and that a warning and/or a modification of the placed netlist of the target configuration takes place if at least one calculated signal propagation time exceeds the threshold value or lies outside of a defined interval.

11. The method according to any one of the preceding claims, **characterized in that** the target configuration comprises at least one multiplexer, particularly disposed directly before a transfer point, and that all added logic element are disposed in new signal paths comprising one single input of the first multiplexer.

12. The method according to claim 11, **characterized in that** the new signal paths comprise at least one interface pin of the programmable logic device, wherein the at least one interface pin is preferably associated with a debugging interface of the programmable logic device.

13. The method according to any one of the preceding claims, **characterized in that** the target configuration comprises at least one second multiplexer, particularly disposed directly after a transfer point, wherein the second multiplexer is connected to at least one input of a logic element.

14. The method according to any one of the preceding claims, **characterized in that** the target configuration comprises at least one added register, wherein the output of the register is preferably connected to an interface pin, particularly one associated with a debugging interface of the programmable logic device.

15. A method for adapting a control device comprising a programmable logic device set up for implementing a control function, wherein the configuration of the programmable logic device is modified by a method according to any one of the preceding claims.

16. A programming device for describing a programmable logic device, comprising a processor, a programming interface, and/or a debugging interface, wherein the device is set up for implementing a method according to any one of the claims 1 through 15.

17. A computer program product having a computer-readable storage medium on which commands are embedded for bringing about the state, when implemented by a processing unit, that the processor is set up for implemented a method according to any one of the claims 1 through 15.

## Revendications

1. Procédé pour modifier la configuration d'un composant logique programmable, dans lequel une configuration initiale (210) du composant logique programmable est lue, de sorte que soit présente, au moins partiellement, une description logique, en particulier une liste de réseaux placée, de la configuration initiale, sachant qu'un ou plusieurs éléments logiques et/ou éléments de liaison sont remplacés ou reconfigurés depuis la description logique de la configuration initiale du composant logique programmable et qu'il est créé une description logique d'une configuration cible présentant un ou plusieurs éléments logiques supplémentaires, sachant qu'aucun, un ou plusieurs éléments de la configuration initiale ne sont pas utilisés dans la configuration cible, sachant qu'un train de bits modifié est créé à partir de la description logique de la configuration cible et sachant que le train de bits modifié est écrit dans le composant logique programmable, **caractérisé en ce que** des points de transfert sont déterminés à l'aide des informations d'affectation (211), donc des éléments logiques présents dans les configurations cible et initiale, en particulier des registres ou des pilotes, auxquels est appliquée une fonction logique modifiée dans la configuration cible (212, 213), sachant que les éléments logiques du composant logique programmable qui sont déjà inutilisés dans la configuration initiale sont marqués comme libres (214, 215),
sachant que les éléments logiques de la configuration initiale qui ne sont plus utilisés, dont les sorties ne sont reliées qu'à des entrées de points de transfert, sont également marqués comme libres (216),
et sachant que les éléments logiques supplémentaires de la configuration cible sont placés sur les éléments logiques marqués comme libres et reliés aux points de transfert via des éléments de liaison inutilisés.

2. Procédé selon la revendication 1, **caractérisé en ce que** les éléments de liaison correspondants sont marqués comme inutilisés par les éléments logiques qui ne sont plus utilisés.

3. Procédé selon la revendication 1 ou 2, **caractérisé en ce que** tous les éléments logiques dont les sorties sont exclusivement connectées à une ou plusieurs entrées d'éléments logiques marqués comme libres dans une étape précédente sont également marqués comme libres de manière récursive, sachant que, de préférence, les éléments de liaison correspondants sont marqués comme inutilisés.

4. Procédé selon l'une des revendications précédentes, **caractérisé en ce que** tous les éléments logiques dans une zone prédéterminée autour d'un ou plusieurs éléments logiques remplacés de la configuration initiale ou d'une entrée d'un point de transfert sont marqués comme libres et les éléments de liaison correspondants sont marqués comme inutilisés, sachant que tous les éléments logiques dans la zone prédéterminée, à l'exception de ou des éléments logiques remplacés, sont ensuite placés à nouveau et connectés à des éléments de liaison inutilisés.

5. Procédé selon la revendication 4, **caractérisé en ce que** les éléments de liaison utilisés dans la configuration initiale, qui se terminent à l'un des éléments logiques dans la zone prédéterminée, sont marqués comme inutilisés au moins jusqu'au prochain élément logique connecté situé en dehors de la zone prédéterminée.

6. Procédé selon l'une des revendications précédentes, **caractérisé en ce que** l'étape de lecture d'une configuration initiale comprend la lecture d'un train de bits et une conversion du train de bits en une description logique au moins pour des parties du train de bits, sachant que la conversion est effectuée en particulier à l'aide d'informations d'architecture du composant logique programmable utilisé.

7. Procédé selon l'une des revendications précédentes, **caractérisé en ce que** le train de bits modifié est créé à l'aide de la configuration cible en établissant, pour les éléments logiques et/ou éléments de liaison modifiés et ainsi reconfigurés, une relation entre la position dans le train de bits et l'élément logique ou l'élément de liaison sur le composant logique programmable et en modifiant le train de bits initial aux positions correspondantes.

8. Procédé selon l'une des revendications 1 à 6, **caractérisé en ce que** le train de bits modifié est créé à l'aide de la configuration cible en ce sens que la liste de réseau placée de la configuration cible est traduite en un nouveau train de bits intégral.

9. Procédé selon l'une des revendications précédentes, **caractérisé en ce que** pour une fonction logique devant être modifiée, qui comprend au moins un trajet de signal, un temps de propagation de signal est déterminé au moins après la modification, sachant qu'un temps de propagation de signal est estimé de préférence pour un trajet de signal dans la configuration cible du composant logique programmable, dans le cours duquel au moins un élément logique ou élément de liaison supplémentaire ou reconfiguré existe, ceci en comptant le nombre des éléments logiques séquentiellement successifs du trajet du signal dans la configuration cible et en attribuant à chaque élément logique un temps de propagation de signal constant.

10. Procédé selon l'une des revendications précédentes, **caractérisé en ce que** au moins un temps de propagation de signal est déterminé pour toutes les fonctions logiques devant être modifiées et/ou tous les trajets de signaux qu'elles comprennent et comparés à une ou plusieurs valeurs seuils, et **en ce qu'**un avertissement et/ou une modification de la liste de réseau placée de la configuration cible a lieu si au moins un temps de propagation de signal déterminé dépasse la valeur seuil ou est situé en dehors d'un intervalle prédéterminé.

11. Procédé selon l'une des revendications précédentes, **caractérisé en ce que** la configuration cible comprend au moins un premier multiplexeur, lequel est en particulier disposé directement devant un point de transfert, et **en ce que** tous les éléments logiques ajoutés sont disposés dans de nouveaux trajets de signaux comprenant une seule entrée du premier multiplexeur.

12. Procédé selon la revendication 11, **caractérisé en ce que** les nouveaux trajets de signaux comprennent au moins une broche d'interface du composant logique programmable, sachant que la au moins une broche d'interface est de préférence attribuée à une interface de débogage du composant logique programmable.

13. Procédé selon l'une des revendications précédentes, **caractérisé en ce que** la configuration cible comprend au moins un second multiplexeur, lequel est en particulier disposé directement derrière un point de transfert, sachant que le second multiplexeur étant relié avec au moins une entrée d'un élément logique.

14. Procédé selon l'une des revendications précédentes, **caractérisé en ce que** la configuration cible comprend au moins un registre ajouté, sachant que la sortie du registre est de préférence reliée avec une broche d'interface qui est en particulier attribuée à une interface de débogage du composant logique programmable.

15. Procédé pour adapter un appareil de commande comprenant un composant logique programmable configuré pour exécuter une fonction de régulation, dans lequel la configuration du composant logique programmable est modifiée par un procédé selon l'une des revendications précédentes.

16. Dispositif de programmation pour décrire un composant logique programmable, comprenant un processeur, une interface de programmation et/ou une interface de débogage, sachant que le dispositif est configuré pour exécuter un procédé selon l'une des revendications 1 à 15.

17. Produit de programme informatique comprenant un support de stockage lisible par ordinateur sur lequel sont incorporées des instructions qui, lorsqu'elles sont exécutées par une unité de calcul, font à ce que l'unité de calcul soit configurée pour exécuter un procédé selon l'une des revendications 1 à 15.
